# EUROPEAN PATENT APPLICATION

(11) **EP 0 529 554 A1**
(43) Date of publication of application: **03.03.1993**
(21) Application number: 92114372.3
(22) Date of filing: 22.08.1992
(51) Int. Cl.: H01L 21/22, H01L 21/225, H01L 33/00

(54) **Method for fabricating a semiconductor device**

(30) Priority: 29.08.1991 JP 244832/91
(71) Applicant: Shin-Etsu Handotai Kabushiki Kaisha, Chiyoda-ku Tokyo 100 (JP)
(72) Inventor: Yamada, Masato, Handotai Isobe Kenkyusho, 13-1 Isobe 2-cho, Annaka-Shi, Gumma-Ken (JP); Takenaka,Takao Handotai Isobe Kenkyusho,Shin-Etsu, Annaki-Shi, Gumma-Ken (JP)
(74) Representative: Reitzner, Bruno, Dr.

(57) **Abstract**

A method for fabricating a semiconductor device includes the steps of forming a second semiconductor layer on a first semiconductor layer which is highly doped with an impurity such as Zn and diffusing the impurity from the first semiconductor layer as an impurity source to the second semiconductor layer to have a predetermined carrier concentration profile, by thermal diffusion, for example. The second semiconductor layer may be formed by epitaxial growth method. Each of the first and second semiconductor layers may consist of preferably a semiconductor included by the III-V periodical group, and more preferably GaAs or GaAlAs.

## Description

### FIELD OF THE INVENTION

This invention relates to a method for fabricating a semiconductor device, and in particular to a method for fabricating a semiconductor device such as a light emitting device provided with a semiconductor layer having a desired carrier concentration profile.

### BACKGROUND OF THE INVENTION

A method for fabricating a semiconductor device such as a light emitting device includes the steps of forming a plurality of semiconductor layers having different conductive types and different carrier concentrations on a semiconductor substrate and forming electrodes on the semiconductor layers. In a method for fabricating a double hetero junction type light emitting device which is most typical of light emitting devices, for example, a three-layer structure consisting of an active layer and a pair of clad layers between which the active layer is sandwiched is formed on a semiconductor substrate. In a method for fabricating such a semiconductor device, impurities are introduced into the semiconductor layers by several kinds of methods in order to make the semiconductor layers have desired carrier concentrations.

In one of the methods for introducing an impurity into a semiconductor layer (the first method), for example, an impurity is diffused from an impurity source located in the outside into a semiconductor layer which has been already formed. In the first method, the impurity which is vaporized from the impurity source such as a solid impurity diffusion source is diffused into the semiconductor layer through the surface thereof, and heating treatment of the semiconductor layer is carried out to make the semiconductor layer have a desired carrier concentration.

In another of the methods for introducing an impurity into a semiconductor layer (the second method), an impurity is already added to materials from which a semiconductor layer is generated, and the semiconductor layer having a desired carrier concentration is generated directly from the materials including the impurity. This method is further divided into two classes, one of which is the vapor phase growth method in which a semiconductor layer is grown from vapor phase materials, and the other of which is the liquid phase growth method in which a semiconductor layer is grown from liquid phase materials.

However, there are disadvantages in these methods mentioned above. In the first method for introducing an impurity into a semiconductor layer, the impurity is diffused through the surface of the semiconductor layer, so that the carrier concentration profile of the semiconductor layer has a tendency in that the carrier concentration is higher in the vicinity of the surface of the semiconductor layer and becomes lower as the distance from the surface in depth increases.

On the other hand, in the second method for introducing an impurity into a semiconductor layer, the carrier concentration depends on the impurity concentration of the material from which the semiconductor layer is generated or the diffusion temperature, etc., so that it is difficult to adjust the carrier concentration after the semiconductor layer is formed.

In particular about a double hetero junction type light emitting device, it has been confirmed by the inventors that the light emitting device has a high luminance if a carrier concentration of a clad layer in the vicinity of an active layer is lower than a predetermined value. Howerver, such a specific carrier concentration profile can not be obtained by the methods shown above.

### SUMMARY OF THE INVENTION

Accordingly, it is an object of this invention to provide a method for fabricating a semiconductor device in which the carrier concentration of a semiconductor layer such as a clad layer of the semiconductor device, especially a double hetero junction type light emitting device, can be controlled to be a targetted value within a relatively low concentration region.

According to a feature of the invention, a method for fabricating a semiconductor device includes the following steps of:
(a)forming a second semiconductor layer on a first semiconductor layer which is highly doped with an impurity; and
(b)diffusing the impurity from the first semiconductor layer as an impurity source to the second semiconductor layer to have a predetermined carrier concentration profile.

In the diffusion step (b), the impurity which is highly doped in the first semiconductor layer diffuses from the first semiconductor layer to the second semiconductor layer through the interface thereof by applying heat. By such a diffusion process, the carrier concentration profile of the second semiconductor layer becomes such that the carrier concentration in the vicinity of the interface with the first semiconductor layer is equal to that of the first semiconductor layer and the carrier concentration becomes lower as the distance from the interface in the first semiconductor layer increases. Therefore, the carrier concentration is very low in the surface of the second semiconductor layer in which the distance from the first layer is the largest. Consequently, it is possible to control the carrier concentration profile of the second semiconductor layer desirably by controlling the carrier concentration of the first semiconductor layer, and the growing temperatures, the growing times and the growing thicknesses of the second semiconductor layer.

The second semiconductor layer may be formed by epitaxial growth method. Each of the first and second semiconductor layers may consist of preferably a semiconductor included in the III-V periodical group, and more preferably GaAs or GaAlAs. The diffusion of the impurity may be carried out by thermal treatment after forming the second semiconductor layer, or with using heat gengerated when forming the second semiconductor layer. The impurity may be Zn which has a high diffusion coefficient, for example.

Therefore, the step (a) may be a step of growing a second semiconductor layer consisting of GaAlAs by epitaxy on a semiconductor substrate which corresponds to a first semiconductor layer consisting of GaAs which is highly doped with Zn, and the step (b) may be a step of diffusing Zn as an impurity from the first semiconductor layer to the second semiconductor layer by thermal diffusion.

### BRIEF DESCRIPTION OF THE DRAWINGS

This invention will be explained in more detail in conjunction with appended drawings, wherein:
Fig. 1 is an explanatory view showing steps of a method for fabricating a light emitting device in a preferred embodiment according to the invention;
Fig. 2 is an explanatory view showing the depth-wise structure of the light emitting device fabricated by the method in the preferred embodiment according to the invention;
Fig. 3 is a graph showing the depth-wise carrier concentration profile of the light emitting device fabricated by the method in the preferred embodiment according to the invention; and
Fig. 4 is a graph showing the relationship between the carrier concentration in the p-type clad layer in the vicinity of the active layer and the relative luminance of the light emitting device.

### DESCRIPTION OF THE PREFERRED EMBODIMENT

A preferred embodiment of this invention will be described below by referring to the attached drawings. In the preferred embodiment, a method for fabricating a double hetero junction type light emitting device will be explained as an example.

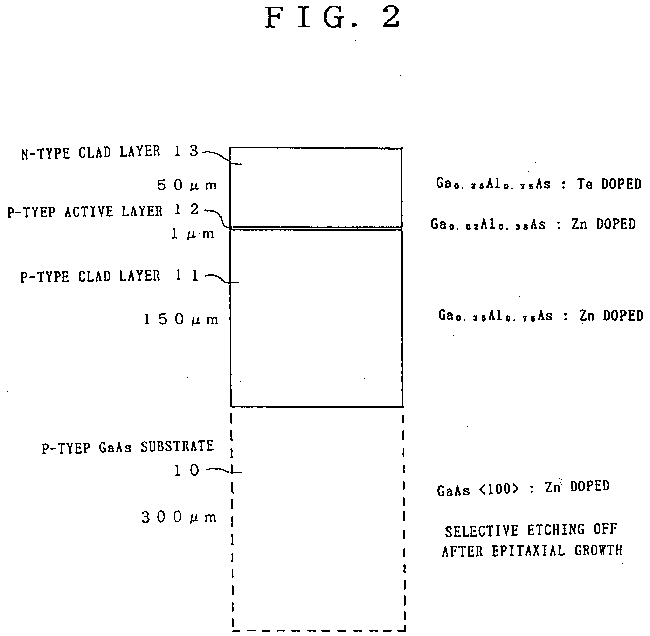

Fig. 2 is a cross-sectional view showing the depth-wise structure of the light emitting device fabricated by the method in the preferred embodiment according to the invention. In the light emitting deivce, a three-layer structure of epitaxial layers is formed on a p-type GaAs <100> substrate 10 doped with Zn of a high concentration as high as 1 to 3 x 10¹⁹ atoms cm⁻³ as an impurity.

In more detail, a p-type clad layer 11 having a thickness of 150 µm consisting of a Ga_{0.25}Al_{0.75}As mixed crystal type compound semiconductor doped with Zn as an impurity to have the predetermined concentration profile in the depth-wise, a p-type active layer 12 having a thickness of 1 µm consisting of a Ga_{0.62}Al_{0.38}As mixed crystal type compound semiconductor doped with Zn as an impurity to have the predetermined concentration, and an n-type clad layer 13 having a thickness of 50 µm consisting of a Ga_{0.25}Al_{0.75}As mixed crystal compound semiconductor doped with Te as an impurity are consecutively grown by epitaxy on a p-type GaAs <100> substrate 10 doped with Zn as an impurity to have a concentration of approximately 1 to 3 x 10¹⁹ atoms cm⁻³. The p-type clad layer 11 of the three layers is doped with Zn as an impurity by the method which charactherizes the method for fabricating the light emitting device in the preferred embodiment. The p-type GaAs substrate 10 may be removed when necessary by selective etching after the epitaxial layers are grown.

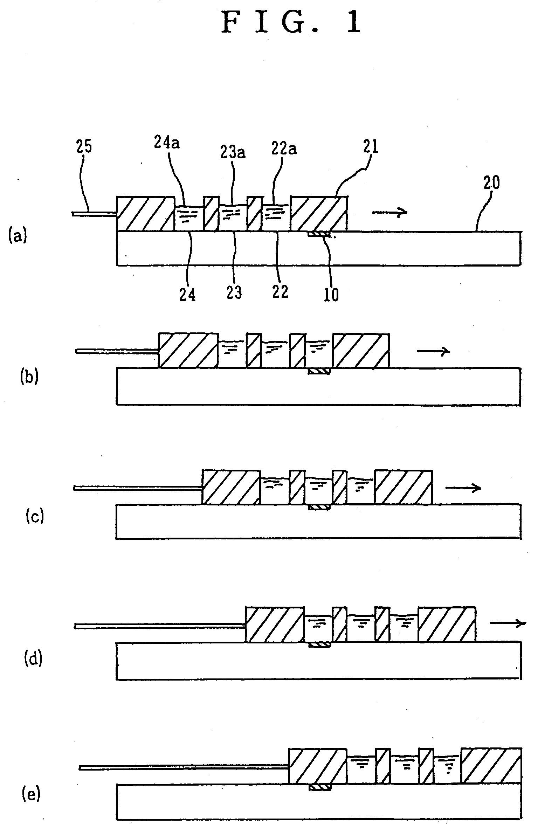

Next, the method for fabricating the light emitting device in the preferred embodiment will be explained in conjunction with Fig. 1. This embodiment shows the method in which each semiconductor layer is grown by the epitaxial growth method, especially the liquid phase growth method. Here, the slide-boat method using a slide-boat is shown. Also shown is the gradual cooling method in which the growing is conducted by lowering the temperature gradually.

In Fig. 1, the p-type GaAs substrate 10 is secured on a boat body 20 in such way that its top surface is flush with the top surface of the boat body 20. A first solution reservoir 22 which contains a clad layer growth solution 22a, a second solution reservoir 23 which contains a p-type active layer growth solution 23a, and a third solution reservoir 24 which contains an n-type clad layer growth solution 24a are set up in a sliding member 21 which slides on the boat body 20. Each solution reservoir does not have a bottom, so that each solution directly soaks the top surface of the boat body 20. The clad layer growth solution 22a and the n-type clad layer growth solution 24a are the solutions consisting mainly of melted Ga_{0.25}Al_{0.75}As. The n-type clad layer growth solution 24a is added with Te as an n-type impurity to have a predetermined concentration, however, the clad layer growth solution 22a is added with no impurity or a very small amount of Zn as a p-type impurity. The p-type clad layer 11 which is to be formed by the clad layer growth solution 22a is supplied with Zn which is diffused from the p-type GaAs substrate 10 in the thermal steps including the step of growing the p-type clad layer 11 and the following step of growing the p-type active layer 12 to have a predetermined concentration profile. On the other hand, the p-type active layer growth solution 23a consits mainly of melted Ga_{0.62}Al_{0.38}As with Zn added as a p-type impurity to have a predetermined concentration. However, an active layer growth solution which is added with no impurity or a very small amount of Zn may be used instead of the p-type active layer growth solution 23a, as like in the case of the clad layer growth solution 22a. In such a case, the p-type active layer 12 which is to be formed by the active layer growth solution is controlled with Zn diffused from the p-type GaAs substrate 10. The sliding member 21 is moved by a handling rod 25.

Now, we describe the process using the equipment described above to form the three epitaxial growth layers on the p-type GaAs substrate 10. First, using the handling rod 25, the sliding member 21 is slidden in the direction of the arrow from the position indicated in Fig. 1(a) to set the p-type clad layer growth solution 22a in the first reservoir 22 on the p-type GaAs substrate 10, and the p-type clad layer 11 is grown under the conditions where the temperature is lowered from 900°C to 800°C , for example (Fig. 1(b)). Then, the sliding member 21 is slidden further in the direction of the arrow to set the p-type active layer growth solution 23a in the second reservoir 23 on the p-type GaAs substrate 10, and the p-type active layer 12 is grown under the conditions where the temperature is lowered from 800°C to 795°C , for example (Fig. 1(c)). The sliding member 21 is then slidden further in the direction of the arrow to grow the n-type clad layer 13 under the conditions where the temperature is lowered from 795°C to 650°C , for example (Fig. 1(d)). In these thermal processes, Zn which is highly doped in the p-type GaAs substrate 10 is diffused to the clad layer, in other words, the so called auto doping occurs. Consecuently, the clad layer becomes the p-type clad layer 11 having a predetermined concentration profile with the low concentration region (1 x 10¹⁶ atoms cm⁻³) in the viciity of the p-type active layer 12. After this, the sliding member 21 is slidden further in the direction of the arrow to complete the growth process (Fig. 1(e)).

After forming the three layer double hetero structure on the p-type GaAs substrate 10, as described above, electrodes are formed on both sides of the three layer structure to obtain the light emitting device. The substrate may be removed by selective etching if necessary.

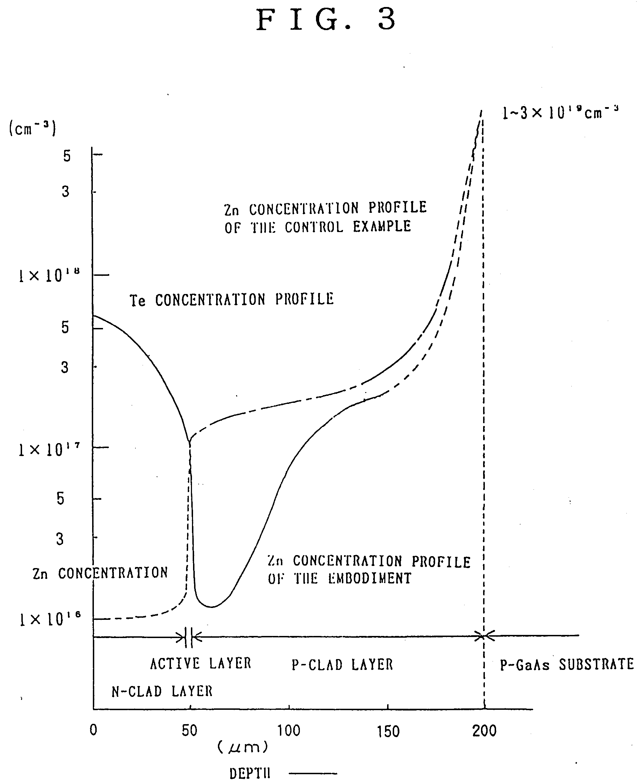

Fig. 3 shows a depth-wise carrier concentration profile of the light emitting device fabricated by the method in the embodiment as described above. The carrier concentration in the p-type clad layer 11 near the p-type GaAs substrate 10 is approximately equivalent to the carrier concentration in the substrate (1 to 3 x 10¹⁹ atoms cm⁻³). However, the closer to the p-type active layer 12, the lower the carrier concentration in the p-type clad layer 11 becomes, and it is as low as 1 x 10¹⁶ atoms cm⁻³ near the junction with the p-type active layer 12. On the other hand, the carrier concentration in the p-type active layer 12 is 1 x 10¹⁷ atoms cm⁻³. The carrier concentration in the n-clad layer 13 increases from 1 x 10¹⁷ atoms cm⁻³, which is equivalent to the carrier concentration in the p-type active layer, to approximately 6 x 10¹⁷ atoms cm⁻³ in the top region. Fig. 3 also shows a depth-wise carrier concentration profile in the p-type clad layer which is grown from the p-type clad layer growth solution which is added with Zn before growth, as a comparable example.

The carrier concentration in the p-type clad layer 11 according to the instant invention is quite low as equal to 5 x 10¹⁶ atoms cm⁻³ or lower in the surface region far from the substrate, that is in the vicinity of the p-type active layer 12, as understood by Fig. 3. It has been confirmed by the inventors that the light emitting device having the carrier concentration profile including the p-type clad layer 11 formed by the method in the preferred embodiment has the high relative luminance.

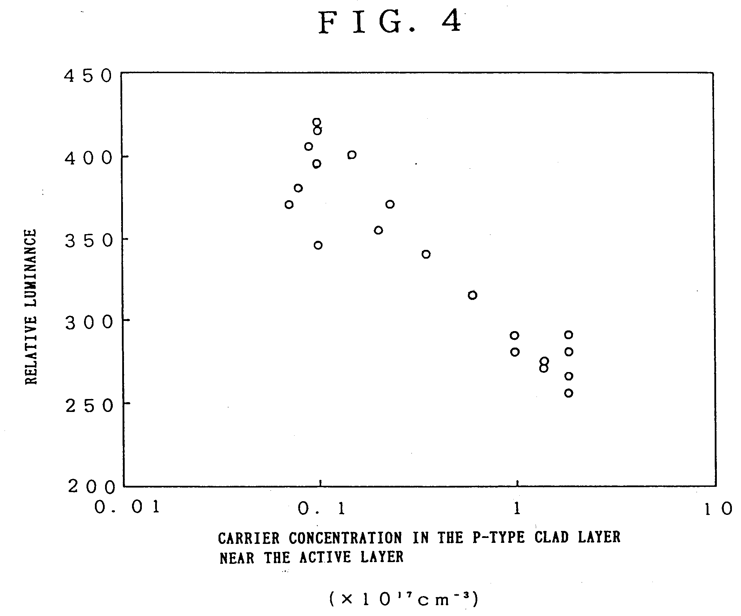

Fig. 4 shows the relationship between the carrier concentration in the p-type clad layer 11 near the p-type active layer 12 and the relative luminance of the light emitting device. It is shown that as the carrier concentration in the p-type clad layer 11 near the p-type active layer 12 decreases, the relative luminance of the light emitting device increases. Especially, the relative luminance for the concentration range 1 to 2 x 10¹⁶ atoms cm⁻³ is very high, approximately 400.

The description in the method for fabricating a semiconductor device in the embodiment has been carried out in case of the double hetero junction type light emitting device, especially in the case of growing each semiconductor layer on a semiconductor substrate by epitaxy, however, the method may be applied to any other semiconductor device. And, a semiconductor layer such as an epitaxicial growth layer which is doped with an impurity of high concentration may be used as an impurity source instead of the semiconductor substrate as in the embodiment. In such a case, a semiconductor layer formed on the other semiconductor layer with highly impurity concentration is doped thereby.

As described above, in a method for fabricating a semiconductor device including a semiconductor layer formed on a semiconductor substrate, the semiconductor layer is doped with an impurity from the semiconductor substrate as an impurity source to make the semiconductor layer have a predetermined carrier concentration, so that it is eble to easily control the carrier concentration of the semiconductor layer such as a clad layer in a double hetero junction type light emitting device to be within the relatively low concentration range. Therefore, a semiconductor device with a high performance can be obtained by the method.

Although the invention has been described with respect to specific embodiment for complete and clear disclosure, the appended claims are not to be thus limited but are to be construed as embodying all modification and alternative constructions that may occur to one skilled in the art which fairly fall within the basic teaching herein set forth.

## Claims

1. A method for fabricating a semiconductor device, comprising the steps of:
(a) forming a second semiconductor layer on a first semiconductor layer which is highly doped with an impurity; and
(b) diffusing said impurity from said first semiconductor layer as an impurity source to said second semiconductor layer to have a predetermined carrier concentration profile.

2. A method according to Claim 1, wherein said second semiconductor layer is an epitaxially grown layer.

3. A method according to Claims 1 or 2: wherein each of said first and second semiconductor layers consists of a semiconductor included in groups III-V of the Periodic Table.

4. A method according to Claims 1 or 2:
wherein said first semiconductor layer consists of GaAs; and said second semiconductor layer consists of GaAlAs.

5. A method according to anyone of Claims 1 to 4:
wherein said first semiconductor layer is doped with Zn.

6. A method according to anyone of Claims 1 to 5:
wherein said first semiconductor layer has a carrier concentration equal to or higher than 5 x 10¹⁷ atoms cm⁻³.

7. A method according to anyone of Claims 1 to 6:
wherein said step (b) of diffusing said impurity from said first semiconductor layer is carried out by using heat generated in a step of forming said second semiconductor layer and/or other layers.

8. A method according to anyone of Claims 1 to 7:
wherein the surface of said second semiconductor layer has a carrier concentration equal to or lower than 5 x 10¹⁶ atoms cm⁻³.

9. A method according to anyone of Claims 1 to 7:
wherein the interface region of said second semiconductor with a third semiconductor layer formed on said semiconductor layer has a carrier concentration equal to or lower than 5 x 10¹⁶ atoms cm⁻³.

10. A method for fabricating a double hetero junction type light emitting device, comprising the steps of:
forming a first semiconductor single crystal layer of GaAs doped with a p-type active impurity of a high concentration; and
growing second to fourth semiconductor single crystal layers of GaAlAs on said first semiconductor single crystal layer by epitaxy, each layer of said second and third semiconductor single crystal layers being doped with no impurity and said fourth semiconductor single crystal layer being doped with an n-type impurity;
wherein growing temperatures and growing speeds of said second to fourth semiconductor single crystal layers are selected to control a carrier concentration profile of said second semiconductor single crystal layer.
